# EUROPEAN PATENT APPLICATION

(11) **EP 4 645 521 A1**
(43) Date of publication of application: **05.11.2025**
(21) Application number: 24787769.9
(22) Date of filing: 23.01.2024
(51) Int. Cl.: H01M 10/48

(54) **BREAKER BOX SYSTEM, POWER SUPPLY SYSTEM, AND VEHICLE**

(30) Priority: 14.04.2023 CN 202310402353
(71) Applicant: Contemporary Amperex Technology Co., Limited, Ningde, Fujian 352100 (CN)
(72) Inventor: YAN, Zhiwei, Ningde, Fujian 352100 (CN); WANG, Chongxi, Ningde, Fujian 352100 (CN); LI, Qiandeng, Ningde, Fujian 352100 (CN); WANG, Xingchang, Ningde, Fujian 352100 (CN)
(74) Representative: Kraus & Lederer PartGmbB
(86) International application number: PCT/CN2024/073719
(87) International publication number: WO 2024/212663

(57) **Abstract**

The present application provides a breaker box system, a power supply system, and a vehicle. The breaker box system comprises a plurality of breaker boxes, the plurality of breaker boxes not sharing a ground. Each breaker box comprises a housing, a battery cell, and an insulation detection assembly, the battery cell and the insulation detection assembly being disposed in the housing. One end of the insulation detection assembly is connected to a positive electrode of the battery cell, the other end is connected to a negative electrode of the battery cell, and a reference ground of the insulation detection assembly is the housing of the breaker box. The embodiments of the present application, by having the plurality of breaker boxes not share a ground, by providing in each breaker box an insulation detection assembly corresponding thereto, and by each insulation detection assembly being used for insulation detection of the corresponding breaker box, achieves the insulation detection of each breaker box not affecting one another, and achieves insulation detection of each breaker box.

## Description

### CROSS-REFERENCE TO RELATED APPLICATION

The present application claims priority to Chinese Patent Application 202310402353.3 filed on April 14, 2023, entitled "ELECTRICAL BOX SYSTEM, POWER SUPPLY SYSTEM AND VEHICLE", the content of which is incorporated herein by reference in its entirety.

### TECHNICAL FIELD

The present application relates to the technical field of battery safety detection, in particular to an electrical box system, a power supply system, and a vehicle.

### BACKGROUND

With the rapid development of the new energy industry nationwide, and to meet market demands, there has been a growing demand in various sectors for higher energy and voltage levels of new energy battery systems. For a battery system with high voltage and high energy density, internal faults caused by poor insulation are quite common, suggesting that higher safety requirements are needed during application.

At present, in the case of insulation detection for multiple electrical boxes, the multiple electrical boxes are typically connected in series and then undergo insulation detection through the use of an insulation detection module. Such an insulation detection approach can only detect, on the whole, whether an electrical box system formed by multiple electrical boxes is insulated or not, but cannot detect the insulation status of every electrical box.

### SUMMARY

An objective of the embodiments of the present application is to provide an electrical box system, a power supply system, and a vehicle, aimed at performing insulation detection on each electrical box among a plurality of electrical boxes.

In a first aspect, an electrical box system is provided according to the embodiments of the present application. The electrical box system includes a plurality of electrical boxes, where the plurality of electrical boxes do not share a common ground. Each electrical box includes a housing, a battery cell, and an insulation detection assembly, where the battery cell and the insulation detection assembly are disposed within the housing. One end of the insulation detection assembly is connected to a positive electrode of the battery cell, and the other end of the insulation detection assembly is connected to a negative electrode of the battery cell. Moreover, a reference ground of the insulation detection assembly is the housing of the electrical box.

According to the embodiments of the present application, a plurality of electrical boxes do not share a common ground, and in each electrical box, a corresponding insulation detection assembly is provided. Each insulation detection assembly is used for insulation detection on the corresponding electrical box. This allows for independent insulation detection on each electrical box, ensuring that the insulation detections of these electrical boxes do not interfere with each other.

In any of the embodiments, the insulation detection assembly includes a first insulation resistor, a second insulation resistor, and a first insulation detector, where a first end of the first insulation resistor is connected to the positive electrode of the battery cell, and a second end of the first insulation resistor is connected to the second insulation resistor; a first end of the second insulation resistor is connected to the negative electrode of the battery cell, and a second end of the second insulation resistor is connected to the first insulation resistor; the first insulation detector is used for acquiring a voltage value of the first insulation resistor and a voltage value of the second insulation resistor.

In the embodiments of the present application, each electrical box is provided with its own insulation detection assembly. Moreover, the first insulation detector in the insulation detection assembly acquires the voltage value of the first insulation resistor and the voltage value of the second insulation detection assembly, respectively, so that insulation detection on the corresponding electrical box is achieved based on the voltage values. This approach reduces errors that result from a change in power source over time, thereby improving the detection accuracy.

In any of the embodiments, the first insulation detector includes a first insulation detection module and a second insulation detection module. The first insulation detection module is connected in parallel with the first insulation resistor and used for detecting the voltage value of the first insulation resistor; the second insulation detection module is connected in parallel with the second insulation resistor and used for detecting the voltage value of the second insulation resistor.

According to the embodiments of the present application, two insulation detection modules are used, with one insulation detection module acquiring the voltage value of one insulation resistor. This not only enables separate insulation detection for each electrical box but also improves the accuracy of the insulation detection.

In any of the embodiments, the insulation detection assembly includes a third insulation resistor, a fourth insulation resistor, and a second insulation detector. One end of the third insulation resistor is connected to the positive electrode of the battery cell, and the other end of the third insulation resistor is connected to the fourth insulation resistor; one end of the fourth insulation resistor is connected to the negative electrode of the battery cell, and the other end of the fourth insulation resistor is connected to the third insulation resistor; the second insulation detector is connected in parallel with the third insulation resistor.

According to the embodiments of the present application, the second insulation detector detects the third insulation resistor so as to achieve insulation detection for the electrical box. This approach not only enables each electrical box to conduct insulation detection independently but also improves the efficiency of insulation detection.

In any of the embodiments, the insulation detection assembly includes a third insulation resistor, a fourth insulation resistor, and a second insulation detector. One end of the third insulation resistor is connected to the positive electrode of the battery cell, and the other end of the third insulation resistor is connected to the fourth insulation resistor; one end of the fourth insulation resistor is connected to the negative electrode of the battery cell, and the other end of the fourth insulation resistor is connected to the third insulation resistor; the second insulation detector is connected in parallel with the fourth insulation resistor.

According to the embodiments of the present application, the second insulation detector detects the fourth insulation resistor so as to achieve insulation detection for the electrical box. This approach not only enables each electrical box to conduct insulation detection independently but also improves the efficiency of insulation detection.

In any of the embodiments, the second insulation detector includes a first analog-to-digital converter, a second analog-to-digital converter, as well as a capacitor, a resistor, and an alternating current power source that are sequentially connected in series. The first analog-to-digital converter is used for acquiring a first amplitude and a first phase between the capacitor and the resistor; the second analog-to-digital converter is used for acquiring a second amplitude and a second phase between the resistor and the alternating current power source.

According to the embodiments of the present application, alternating current is injected through the alternating current power source, and the amplitude and phase through the resistor are detected by the second insulation detector, so that the insulation detection speed can be improved.

In any of the embodiments, the plurality of electrical boxes in the electrical box system are connected in series, in parallel, or in series-parallel. Therefore, the embodiments of the present application can be applied to scenarios where a plurality of electrical boxes are connected in series, in parallel, or in series-parallel. In these scenarios, the electrical boxes can undergo insulation detection without mutual interference.

In any of the embodiments, for a case where the plurality of electrical boxes are connected in parallel, each electrical box is connected to a main positive terminal through a main positive relay and to a main negative terminal through a main negative relay.

In the embodiments of the present application, a plurality of electrical boxes do not share a common ground, and in each electrical box, a corresponding insulation detection assembly is provided, so that the impact of the opening or closing of the relay corresponding to the electrical box on the insulation detection of other electrical boxes is reduced.

In a second aspect, another electrical box system is provided according to the embodiments of the present application. The electrical box includes a first electrical box group and a second electrical box group. The first electrical box group and the second electrical box group do not share a common ground; the first electrical box group includes a first insulation detection module and a plurality of first electrical boxes sharing a common ground, and the first insulation detection module is used for performing insulation detection on the plurality of first electrical boxes sharing the common ground; the second electrical box group includes a plurality of second electrical boxes that do not share a common ground, and each second electrical box includes a housing, as well as a battery cell and a second insulation detection module disposed within the housing; one end of the second insulation detection module is connected to a positive electrode of the battery cell, and the other end of the second insulation detection module is connected with a negative electrode of the battery cell; a reference ground of the second insulation detection module is the housing.

In the embodiments of the present application, some of the electrical boxes sharing a common ground are subjected to insulation detection using one insulation detection module, while electrical boxes that do not share a common ground are each subjected to insulation detection using separate insulation detection modules. This allows for independent insulation detection of each electrical box that does not share a common ground.

In a third aspect, a power supply system is provided according to the embodiments of the present application. The power supply system includes a battery management system and the electrical box system according to the first aspect, where the battery management system is connected to the electrical box system.

In a fourth aspect, a vehicle is provided according to the embodiments of the present application. The vehicle includes the power supply system according to the second aspect.

Additional features and advantages of the present application will be set forth in the following description, and some will become apparent from the description or may be learned by practicing the embodiments of the present application. The objectives and other advantages of the present application can be achieved and attained by the structure particularly stated in the written description, claims, and drawings.

### BRIEF DESCRIPTION OF THE DRAWINGS

In order to more clearly illustrate the technical solutions in the embodiments of the present application, the drawings required for use in the embodiments of the present application will be briefly described below. It should be understood that the following drawings only illustrate some embodiments of the present application and therefore should not be considered as limiting the scope of the present application, and other related drawings can be derived from these drawings by those of ordinary skill in the art without creative efforts.
FIG. 1 is a schematic structural diagram of an electrical box system according to an embodiment of the present application;
FIG. 2 is a schematic diagram of an internal structure of an electrical box according to an embodiment of the present application;
FIG. 3 is a schematic diagram of an internal circuit of an electrical box according to an embodiment of the present application;
FIG. 4 is a schematic structural diagram of another electrical box according to an embodiment of the present application;
FIG. 5 is a schematic diagram of an internal circuit of another electrical box according to an embodiment of the present application;
FIG. 6 is a schematic structural diagram of yet another electrical box according to an embodiment of the present application;
FIG. 7 is a schematic structural diagram of still another electrical box according to an embodiment of the present application;
FIG. 8 is a schematic structural diagram of an internal circuit of yet another electrical box according to an embodiment of the present application;
FIG. 9 is a schematic structural diagram illustrating a serial connection of a plurality of electrical boxes according to an embodiment of the present application;
FIG. 10 is a schematic structural diagram illustrating a parallel connection of a plurality of electrical boxes according to an embodiment of the present application; and
FIG. 11 is a schematic structural diagram of a power supply system according to an embodiment of the present application.

### DETAILED DESCRIPTION

Embodiments of the technical solutions of the present application will be described in detail below with reference to the drawings. The following embodiments are only for illustrating the technical solutions of the present application more clearly, and therefore are only exemplary and do not limit the claimed scope of the present application.

Unless otherwise defined, all technical and scientific terms used herein have the same meaning as commonly understood by those skilled in the technical field to which the present application belongs. The terms used herein are only for illustrating the specific embodiments, rather than limiting the present application. The terms "include", "comprise" and "provided with", and any variations thereof in the specification and claims of the present application and the above-mentioned drawing description encompass non-exclusive inclusions.

In the description of the embodiments of the present application, technical terms such as "first", "second", and the like are only used to distinguish different objects and should not be interpreted as indicating or implying the relative importance or implicitly indicating the number, specific order, or primary and secondary relationship of the noted technical features. In the description of the embodiments of the present application, unless otherwise specifically defined, "plurality of" means two or more.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality of" refers to no less than two (including two). Similarly, "plurality of groups" refers to no less than two (including two) groups, and "plurality of pieces" refers to no less than two (including two) pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise" "counterclockwise", "axial", "radial", "circumferential" and the like indicating directional or positional relationships are based on the directional or positional relationships shown in the drawings and are merely for the convenience of describing the embodiments of the present application and simplifying the description, rather than indicating or implying that the noted devices or elements must have specific directions or must be constructed and operated in specific directions. Therefore, these terms should not be construed as limitations on the embodiments of the present application.

In the description of the embodiments of the present application, unless otherwise clearly specified and defined, the technical terms "mount", "interconnect", "connect", "fix", and the like should be interpreted in their broad senses. For example, "connect" may be "fixedly connect", "detachably connect", or "integrally connect"; "mechanically connect" or "electrically connect"; or "directly interconnect", "indirectly interconnect through an intermediate", "communication between interiors of two elements", or "interaction between two elements". In addition, switches, resistors, protection circuits, diagnosis circuits, and the like may also be disposed between two connected ends and used for controlling and protecting the whole circuit. For those of ordinary skill in the art, the specific meanings of the above terms in the embodiments of the present application can be interpreted according to specific conditions.

At present, with the rapid development of the new energy industry, new energy batteries have been applied in various fields, such as new energy vehicles and electric vehicles, and as energy storage systems. New energy vehicles or energy storage systems are powered by a single electrical box or by a plurality of electrical boxes that are connected in series/parallel.

A new energy vehicle can be divided into a high-voltage part, a low-voltage part, and a vehicle body ground. The high-voltage part mainly includes a battery, a charge-discharge circuit, a high-voltage monitor, and other such parts. The low-voltage part mainly includes a low-voltage power supply, a CPU circuit, a communication control circuit, etc. The vehicle body ground is generally a vehicle body shell, a metal shell of the modules and upper and lower housings for a battery pack are also connected with the vehicle body ground, and passengers are also in direct contact with the vehicle body. For personnel safety, it is essential to maintain a certain level of insulation performance between the high-voltage part and the vehicle body ground. This prevents the formation of a leakage current path to the vehicle body ground due to the high voltage circuit and avoids any harm to people.

In a case where an electrical box system is formed by a plurality of electrical boxes connected in series/parallel, there is only one insulating reference ground for the entire electrical box system. For example, the insulating ground for a new energy vehicle is the vehicle body chassis, and the insulating ground for an energy storage system is the ground. With one insulation detection module, insulation detection can be achieved for the entire electrical box system, thereby determining whether the insulation performance of the electrical box system meets the requirement. During insulation detection, when insulation detection results show that the insulation performance does not meet the requirement, the specific electrical boxes with a leakage fault in the electrical box system cannot be determined. Therefore, the current insulation detection schemes for the electrical box system fail to achieve insulation detection on each electrical box in the electrical box system formed by a plurality of electrical boxes.

To solve the above technical problem, an electrical box system is provided according to the embodiments of the present application. A plurality of electrical boxes in the electrical box system do not share a common ground. Additionally, an insulation detection assembly is disposed in each electrical box, and the insulation detection assembly is responsible for detecting insulation within its corresponding electrical box. This setup achieves the goal of independent insulation detection for each electrical box in the electrical box system, ensuring that the insulation detection of one electrical box does not affect the others.

It can be understood that the electrical box system according to the embodiments of the present application can be applied to, but not limited to, electrical vehicles, electrical bicycles, electrical toys, ships, spacecrafts, etc. The electrical toys may include stationary or mobile electrical toys, such as game consoles, electrical car toys, electrical ship toys, or electrical airplane toys. The spacecrafts may include airplanes, rockets, space shuttles, spaceships, etc.

The electrical box in the embodiments of the present application may also be referred to as a battery case, an electrical cabinet, a battery pack, etc.

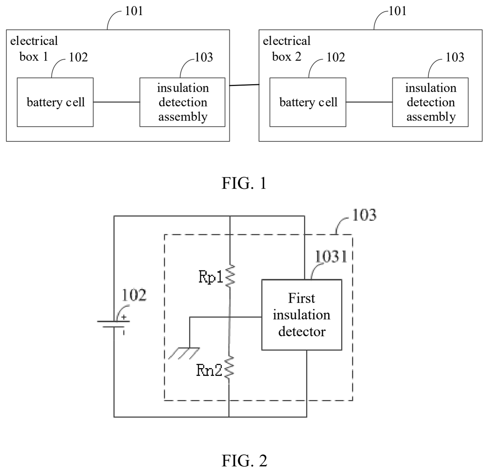

FIG. 1 is a schematic structural diagram of an electrical box system according to an embodiment of the present application. As shown in FIG. 1, the electrical box system includes a plurality of electrical boxes 10, and the plurality of electrical boxes do not share a common ground. Each electrical box 10 includes a housing 101, a battery cell 102, and an insulation detection assembly 103, where the battery cell 102 and the insulation detection assembly 103 are disposed within the housing 101. One end of the insulation detection assembly 103 is connected to the positive electrode of the battery cell 102, and the other end of the insulation detection assembly 103 is connected to the negative electrode of the battery cell 102. Moreover, the reference for the insulation detection assembly 103 may be the housing 101 of the electrical box 101. It should be noted that FIG. 1 only illustrates the electrical box system formed by two electrical boxes, but in practical application, the number of electrical boxes forming the electrical box system is not limited to two.

During specific implementation, the material of the housing 101 of the electrical box 10 may be an insulating material or a conductive material. On one hand, the housing 101 is used for protecting the battery and the insulation detection assembly therein, and on the other hand, the housing 101 may serve as the reference ground for the insulation detection assembly. The housing 101 may have a plurality of structures, such as a square structure, a rectangular parallelepiped structure, or a hexahedral structure.

There may be a plurality of battery cells 102, and the plurality of battery cells 102 may be connected in series, in parallel, or in series-parallel. The series-parallel connection means that both series connection and parallel connection are present in the connection of the plurality of battery cells 102. The plurality of battery cells 102 may be directly connected in series, in parallel, or in series-parallel, and the whole formed by the plurality of battery cells 102 is then accommodated in the housing 101. Certainly, the electrical box 101 may also be formed in such a manner where at first, the plurality of battery cells 102 are connected in series, in parallel, or in series-parallel to form battery modules, and then the plurality of battery modules are connected in series, in parallel, or in series-parallel to form a whole, which is accommodated in the housing 101.

The insulation detection assembly 103 is used for performing insulation detection on the electrical box; one end of the insulation detection assembly 103 is connected with the positive electrode of the battery cell 102, and the other end of the insulation detection assembly 103 is connected with the negative electrode of the battery cell 102. It can be understood that in the case where a plurality of battery cells 102 are connected in series, in parallel, or in series-parallel, the positive electrodes of the battery cells 102 are the positive electrode of the whole formed by connecting the plurality of battery cells 102, and the negative electrodes of the battery cells 102 are the negative electrode of the whole formed by connecting the plurality of battery cells 102. As for the specific structure of the insulation detection assembly 103, any structure that can achieve the insulation detection function for the electrical box 101 is possible.

It can be understood that in the embodiments of the present application, the connection among various components, for example, one end of the insulation assembly connected to the positive electrode of the battery cell and the other end of the insulation assembly connected to the negative electrode of the battery cell, can be achieved either directly via wires or by providing switches, resistors, protection circuits, diagnosis circuits, and the like between the two ends. The meaning of the connection in the following embodiments is the same as above, and the description thereof is omitted in the following embodiments.

According to the embodiments of the present application, a plurality of electrical boxes do not share a common ground, and in each electrical box, a corresponding insulation detection assembly is provided. Each insulation detection assembly is used for insulation detection on the corresponding electrical box. This allows for independent insulation detection on each electrical box, ensuring that the insulation detections of these electrical boxes do not interfere with each other.

Insulation detections based on a bridge method and an alternating current (AC) injection method will be described below, respectively.

The bridge method involves measuring absolute voltage values U+ and U- of the positive and negative electrodes of a battery cell to a reference ground. If U+ > U-, then insulation resistor Rp is greater than insulation resistor Rn; in this case, a resistor R0 is connected in parallel to the insulation resistor Rp, and the absolute voltage values U+ and U-are measured again. If U+ < U-, then insulation resistor Rp is less than insulation resistor Rn; in this case, a resistor R0' is connected in parallel to the insulation resistor Rp, and the absolute voltage values U+ and U- are measured again. Based on the measured absolute voltage values U+ and U- as well as the insulation resistor Rp, the insulation resistor Rn, and the resistors in parallel connection, an equation is constructed for calculation, so as to obtain the specific resistance values of the insulation resistor Rp and the insulation resistor Rn. Whether the electrical box satisfies the requirements of insulation performance is determined based on the resistance values.

The AC injection method is characterized in that measurement is not affected by a direct current (DC) power source and can proceed while the DC power source is operational or shut down. The primary circuit in the AC injection method includes a capacitor, a resistor, and a low-frequency signal generator (i.e., the AC power source in the embodiments of the present application). The AC injection method follows the principle that an alternating voltage with periodic polarity reversal and a detection resistor are connected in parallel with the insulation resistor of a particular electrode, insulation resistance can be calculated by detecting the current passing through the detection resistor, and based on the calculated value of the insulation resistance, it is determined whether the electrical box satisfies the requirement of insulation performance.

Based on the above embodiment, the insulation detection assembly includes a first insulation resistor, a second insulation resistor, and a first insulation detector. The first end of the first insulation resistor is connected to the positive electrode of the battery cell, and the second end of the first insulation resistor is connected to the second insulation resistor; the first end of the second insulation resistor is connected to the negative electrode of the battery cell, and the second end of the second insulation resistor is connected to the first insulation resistor; the first insulation detector is used for acquiring the voltage value of the first insulation resistor and the voltage value of the second insulation resistor.

During specific implementation, FIG. 2 is a schematic diagram of an internal structure of an electrical box according to an embodiment of the present application. As shown in FIG. 2, which illustrates the internal structure of one electrical box 101, the electrical box 101 includes a battery cell 102 and an insulation detection assembly 103 therein; the insulation detection assembly 103 includes a first insulation resistor Rp1, a second insulation resistor Rn2, and a first insulation detector 1031.

The first insulation resistor Rp1 is a resistor disposed between the positive electrode of the battery cell 102 and the reference ground, and thus, one end of the first insulation resistor Rp1 is connected to the positive electrode of the battery cell 102, and the other end of the first insulation resistor Rp1 is connected to the second insulation resistor Rn2 and the reference ground. The second insulation resistor Rn2 is a resistor disposed between the negative electrode of the battery cell 102 and the reference ground, and thus, one end of the second insulation resistor Rn2 is connected to the first insulation resistor Rp1 and the reference ground, and the other end of the second insulation resistor Rn2 is connected to the negative electrode of the battery cell 102. It should be noted that the resistance values of the first insulation resistor Rp1 and the second insulation resistor Rn2 are set according to actual needs.

The first insulation detector 1031 is used to detect a voltage value of the first insulation resistor Rp1 and a voltage value of the second insulation resistor Rn2, and determine, based on the detected voltage values, whether the insulation performance of the electrical box satisfies the requirement. Therefore, the first insulation detector 1031 is a device that can be used for voltage acquisition.

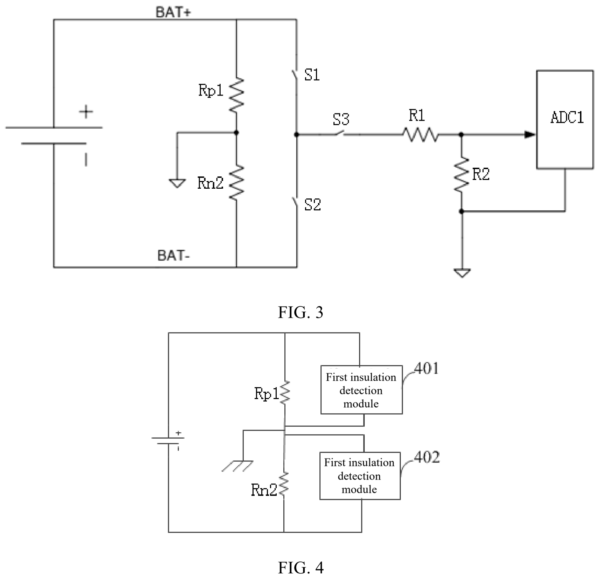

FIG. 3 is a schematic diagram of an internal circuit of an electrical box according to an embodiment of the present application. As shown in FIG. 3, the electrical box includes: a battery cell and an insulation detection assembly. The insulation detection assembly includes a first insulation resistor Rp1, a second insulation resistor Rn2, a switch S1, a switch S2, a switch S3, a resistor R1, a resistor R2, and an analog-to-digital converter ADC1.

The first end of the switch S1 is connected to the first end of the first insulation resistor Rp1, and the second end of the switch S1 is connected to the first end of the switch S2 and the first end of the switch S3, respectively.

The second end of the switch S2 is connected to the first end of the second insulation resistor Rn2.

The first end of the switch S3 is also connected to the first end of the switch S2, and the second end of the switch S3 is connected to the first end of the resistor R1.

The second end of the resistor R1 is connected to the first end of the resistor R2 and the analog-to-digital converter ADC1, respectively.

The second end of the resistor R2 is connected to the analog-to-digital converter ADC1 and the reference ground.

The analog-to-digital converter ADC1 is used to acquire voltage values of the switch S1, the switch S2, and the switch S3 in different states, and perform insulation detection based on the acquired voltage values.

In the embodiments of the present application, each electrical box is provided with its own insulation detection assembly. Moreover, the first insulation detector in the insulation detection assembly acquires the voltage value of the first insulation resistor and the voltage value of the second insulation detection assembly, respectively, so that insulation detection on the corresponding electrical box is achieved based on the voltage values. This approach reduces errors that result from a change in power source over time, thereby improving the detection accuracy.

Based on the above embodiment, the first insulation detector includes a first insulation detection module and a second insulation detection module. The first insulation detection module is connected in parallel with the first insulation resistor and used for detecting the voltage value of the first insulation resistor; the second insulation detection module is connected in parallel with the second insulation resistor and used for detecting the voltage value of the second insulation resistor.

During specific implementation, FIG. 4 is a schematic structural diagram of another electrical box according to an embodiment of the present application. As shown in FIG. 4, which also only illustrates the internal structure of one electrical box, the internal structures of a plurality of electrical boxes in the electrical box system may either all be the same as the structure shown in FIG. 4, or some electrical boxes have the structure shown in FIG. 4 while others have different structures, such as the structure shown in FIG. 2. The first insulation detector includes a first insulation detection module 401 and a second insulation detection module 402. The first insulation detection module 401 is connected in parallel with the first insulation resistor Rp1 and used for detecting the voltage value of the first insulation resistor Rp1; the second insulation detection module 402 is connected in parallel with the second insulation resistor Rn2 and used for detecting the voltage value of the second insulation resistor Rn2. It can be understood that the first insulation detection module 401 and the second insulation detection module 402 are both devices that can be used for voltage detection.

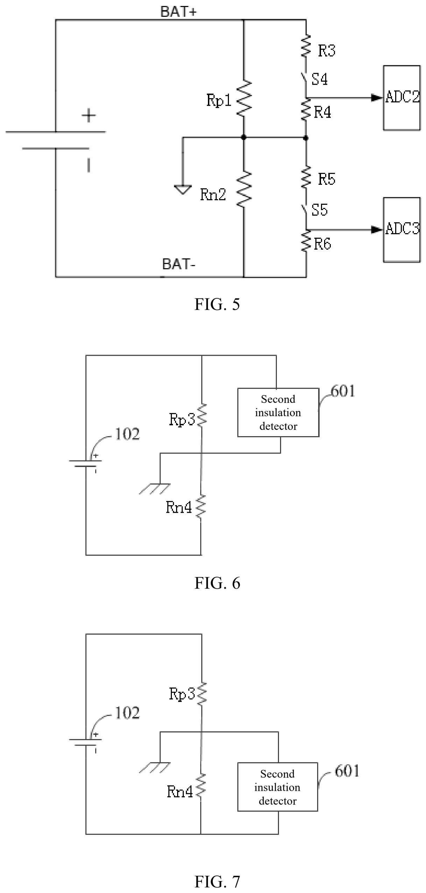

FIG. 5 is a schematic diagram of an internal circuit of another electrical box according to an embodiment of the present application. As shown in FIG. 5, the electrical box includes: a battery cell and an insulation detection assembly. The insulation detection assembly includes a first insulation resistor Rp1, a second insulation resistor Rn2, a first insulation detection module, and a second insulation detection module.

The first insulation detection module includes an analog-to-digital converter ADC2 as well as a resistor R3, a switch S4, and a resistor R4 that are sequentially connected in series. The second analog-to-digital converter is used for acquiring the voltage value between the switch S4 and the resistor R4.

The second insulation detection module includes an analog-to-digital converter ADC3 as well as a resistor R5, a switch S5, and a resistor R6 that are sequentially connected in series. The analog-to-digital converter ADC3 is used for acquiring the voltage value between the switch S5 and the resistor R6.

Insulation detection is performed based on the voltage values acquired by the analog-to-digital converter ADC2 and the analog-to-digital converter ADC3.

According to the embodiments of the present application, two insulation detection modules are used, with one insulation detection module acquiring the voltage value of one insulation resistor. This not only enables separate insulation detection for each electrical box but also improves the accuracy of the insulation detection.

Based on the above embodiment, the insulation detection assembly includes a third insulation resistor, a fourth insulation resistor, and a second insulation detector. One end of the third insulation resistor is connected to the positive electrode of the battery cell, and the other end of the third insulation resistor is connected to the fourth insulation resistor; one end of the fourth insulation resistor is connected to the negative electrode of the battery cell, and the other end of the fourth insulation resistor is connected to the third insulation resistor; the second insulation detector is connected in parallel with the third insulation resistor.

During specific implementation, FIG. 6 is a schematic structural diagram of yet another electrical box according to an embodiment of the present application, as shown in FIG. 6. The third insulation resistor Rp3 is a resistor disposed between the positive electrode of the battery cell 102 and the reference ground, and thus, one end of the third insulation resistor Rp3 is connected to the positive electrode of the battery cell 102, and the other end of the third insulation resistor Rp3 is connected to the fourth insulation resistor Rn4 and the reference ground. The fourth insulation resistor Rn4 is a resistor disposed between the negative electrode of the battery cell 102 and the reference ground, and thus, one end of the fourth insulation resistor Rn4 is connected to the third insulation resistor Rp3 and the reference ground, and the other end of the fourth insulation resistor Rn4 is connected to the negative electrode of the battery cell 102. It should be noted that the resistance values of the third insulation resistor Rp3 and the fourth insulation resistor Rn4 are set according to actual needs.

The second insulation detector 601 is used to detect the voltage value of the third insulation resistor Rp3, and determine, based on the detected voltage value, whether the insulation performance of the electrical box satisfies the requirement. Therefore, the second insulation detector 601 is a device that can be used for voltage acquisition.

It can be understood that in the electrical box system, the internal structures of a plurality of electrical boxes may either all be the same as the structure shown in FIG. 6, or some electrical boxes may have the structure shown in FIG. 6 while the remaining electrical boxes have other structures, such as the electrical box structures shown in the above embodiments.

According to the embodiments of the present application, the second insulation detector detects the third insulation resistor so as to achieve insulation detection for the electrical box. This approach not only enables each electrical box to conduct insulation detection independently but also improves the efficiency of insulation detection.

Based on the above embodiment, the insulation detection assembly includes a third insulation resistor, a fourth insulation resistor, and a second insulation detector. One end of the third insulation resistor is connected to the positive electrode of the battery cell, and the other end of the third insulation resistor is connected to the fourth insulation resistor; one end of the fourth insulation resistor is connected to the negative electrode of the battery cell, and the other end of the fourth insulation resistor is connected to the third insulation resistor; the second insulation detector is connected in parallel with the fourth insulation resistor.

During specific implementation, FIG. 7 is a schematic structural diagram of yet another electrical box according to an embodiment of the present application. As shown in FIG. 7, the electrical box includes a battery cell and an insulation detection assembly. The insulation detection image includes a third insulation resistor Rp3, a fourth insulation resistor Rn4, and a second insulation detector 601. It can be understood that for the third insulation resistor and the fourth insulation resistor, reference may be made to the descriptions in the above embodiments, and the details will not be repeated here.

The second insulation detector 601 is used to detect the voltage value of the fourth insulation resistor Rp4, and determine, based on the detected voltage value, whether the insulation performance of the electrical box satisfies the requirement. Therefore, the second insulation detector 601 is a device that can be used for voltage acquisition.

It can be understood that in the electrical box system, the internal structures of a plurality of electrical boxes may either all be the same as the structure shown in FIG. 7, or some electrical boxes may have the structure shown in FIG. 7 while the remaining electrical boxes have other structures, such as the electrical box structures shown in the above embodiments.

According to the embodiments of the present application, the second insulation detector detects the fourth insulation resistor so as to achieve insulation detection for the electrical box. This approach not only enables each electrical box to conduct insulation detection independently but also improves the efficiency of insulation detection.

Based on the above embodiments, the second insulation detector includes a first analog-to-digital converter, a second analog-to-digital converter, as well as a capacitor, a resistor, and an AC power source that are sequentially connected in series. The first analog-to-digital converter is used for acquiring a first amplitude and a first phase between the capacitor and the resistor; the second analog-to-digital converter is used for acquiring a second amplitude and a second phase between the resistor and the AC power source.

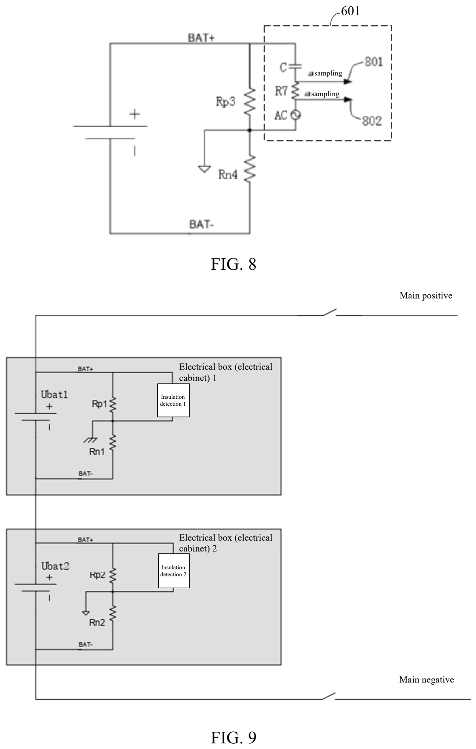

During specific implementation, FIG. 8 is a schematic structural diagram of an internal circuit of yet another electrical box according to an embodiment of the present application. As shown in FIG. 8, the internal circuit of the electrical box includes a battery cell and an insulation detection assembly. The insulation detection assembly includes a third insulation resistor Rp3, a fourth insulation resistor Rn4, and a second insulation detector 601. The second insulation detector 601 includes a capacitor C, a resistor R7, an AC power source, a first analog-to-digital converter 801, and a second analog-to-digital converter 802. It can be understood that the second insulation detector 601 shown in FIG. 8 is disposed between a high-voltage positive electrode and a low-voltage ground, and in practical applications, the second insulation detector 601 may also be disposed between a high-voltage negative electrode and the low-voltage ground.

The first analog-to-digital converter 801 acquires the first amplitude and the first phase between the capacitor C and the resistor R7; the second analog-to-digital converter 802 acquires the second amplitude and the second phase between the resistor R7 and the AC power source. The insulation resistance value is calculated based on the first amplitude, the first phase, the second amplitude, and the second phase to achieve insulation detection.

According to the embodiments of the present application, alternating current is injected through the alternating current power source, and the amplitude and phase through the resistor are detected by the second insulation detector, so that the insulation detection speed can be improved.

Based on the above embodiments, the plurality of electrical boxes in the electrical box system are connected in series, in parallel, or in series-parallel.

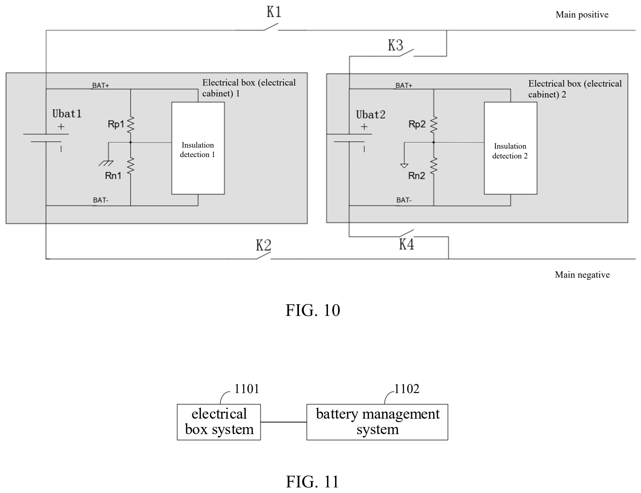

During specific implementation, FIG. 9 is a schematic structural diagram illustrating a serial connection of a plurality of electrical boxes according to an embodiment of the present application, and FIG. 10 is a schematic structural diagram illustrating a parallel connection of a plurality of electrical boxes according to an embodiment of the present application, as shown in FIG. 9 and FIG. 10. It can be understood that during specific implementation, the plurality of electrical boxes may also be connected in series-parallel. In the case of serial connection, parallel connection, and series-parallel connection, the plurality of electrical boxes do not share a common ground. The internal structures of the electrical boxes in the electrical box system may be completely the same or different. Specifically, the internal structure of the electrical box may be one of the electrical box structures according to the above embodiments. The insulation detection assembly within each electrical box is capable of performing insulation detection for this electrical box.

It should be noted that the electrical box structure according to the embodiments of the present application, apart from the insulation detection assemblies described in the above embodiments, may also be formed by other structures capable of achieving the insulation detection function. Different structures correspond to different insulation detection methods, which may be, for example, the megohmmeter method, ungrounded grounding method, auxiliary power supply method, or high-voltage injection method.

The embodiments of the present application can be applied in scenarios where a plurality of electrical boxes are connected in series, in parallel, or in series-parallel. In these scenarios, the electrical boxes can undergo insulation detection without mutual interference.

Based on the above embodiments, for the case where a plurality of electrical boxes are connected in parallel, each electrical box is connected to a main positive terminal through a main positive relay and to a main negative terminal through a main negative relay.

As shown in FIG. 10, an electrical box 1 is connected to a main positive terminal through a main positive relay K1, and the electrical box 1 is connected to a main negative terminal through a main negative relay K2. An electrical box 2 is connected to the main positive terminal through a main positive relay K3, and the electrical box 1 is connected to the main negative terminal through a main negative relay K4.

In the case where the relays are all open, high voltages and low voltages (housings) of the electrical box 1 and the electrical box 2 are all independent, and insulation detection 1 and insulation detection 2 work independently without mutual interference.

In the case where the relays are all closed, high voltages of the electrical boxes 1 and 2 are connected together and yet low voltages (housings) are independent, and similarly, insulation detection 1 and insulation detection 2 also work independently without mutual interference.

Therefore, the embodiments of the present application achieve the insulation detection function for two electrical boxes that are connected in parallel and do not share a common ground.

In practical applications, there may be situations where some electrical boxes in the electrical box system must share a common ground. Therefore, in another electrical box system according to the embodiments of the present application, the electrical boxes that share a common ground form a first electrical box group, and the electrical boxes that do not share a common ground form a second electrical box group. The first electrical box group includes a first insulation detection module and a plurality of first electrical boxes sharing a common ground. The first insulation detection module is used for performing insulation detection on the plurality of first electrical boxes sharing a common ground.

The second electrical box group includes a plurality of second electrical boxes that do not share a common ground. Each second electrical box includes a housing, as well as a battery cell and a second insulation detection module disposed within the housing; one end of the second insulation detection module is connected to the positive electrode of the battery cell, and the other end of the second insulation detection module is connected to the negative electrode of the battery cell; the reference ground of the second insulation detection module is the housing.

During specific implementation, the electrical box system may include a plurality of first electrical box groups. In each first electrical box group, the first electrical boxes share a common ground, and different first electrical box groups do not share a common ground. The electrical box system may have one or a plurality of second electrical box groups, and the second electrical boxes in the second electrical box group do not share a common ground.

Since the first electrical boxes in the first electrical box group share a common ground, one first insulation detection module may be utilized to perform insulation detection on the first electrical box group.

Since the second electrical boxes in the second electrical box group do not share a common ground, each electrical box in the second electrical box group has its own second insulation detection module. It can be understood that the first insulation detection module and the second insulation detection module are consistent, in terms of both internal structure and function, with the insulation detection assemblies in the above embodiments, and the details will not be repeated here.

Therefore, in the embodiments of the present application, electrical boxes that must share a common ground are detected using one first insulation detection module, while electrical boxes that do not share a common ground are each detected using one separate second insulation detection module. Therefore, at the time of insulation detection, the electrical boxes that do not share a common ground can be detected independently without mutual interference.

FIG. 11 is a schematic structural diagram of a power supply system according to an embodiment of the present application. As shown in FIG. 11, a battery management system 1102 is connected to an electrical box system 1101. Specifically, this connection may be an electrical connection or a wireless communication connection.

It can be understood that for the specific structure of the electrical box system 1101, reference may be made to the above embodiments, and the details will not be repeated here. The battery management system 1102 is used for controlling the charging and discharging of the battery cell in the electrical box system 1101, and monitoring parameters, such as temperature, of the battery cell. In addition, the battery management system 1102 may also control insulation detection for the electrical box by the insulation detection assembly.

A vehicle is further provided according to the embodiments of the present application. The vehicle includes the power supply system described in the above embodiment. It can be understood that the vehicle may further include other components, including but not limited to: the engine, chassis, steering wheel, dashboard, etc. The vehicle may be any of the aforementioned devices or systems that employ the electrical box system.

In the embodiments according to the present application, it should be understood that the disclosed apparatuses and methods may be implemented in other ways. The above-described apparatus embodiments are merely illustrative. For example, the division of the units is merely a logical functional division, and in actual implementation, there may be other division methods. For another example, a plurality of units or assemblies may be combined or integrated into another system, or some features may be omitted or not executed. In addition, the coupling, direct coupling, or communication connection between each other that is shown or discussed may be indirect coupling or communication connection through some communication interfaces, apparatuses, or units, and it may be in electrical, mechanical, or other forms.

In addition, the units described as separate parts may or may not be physically separate, and parts displayed as units may or may not be physical units, that is, they may be located in one place or distributed across a plurality of network units. Some or all of the units may be selected according to actual needs to achieve the purpose of the solutions of the embodiments.

Furthermore, the functional modules in the embodiments of the present application may be integrated together to form an independent part, or each module may exist alone, or two or more modules may be integrated to form an independent part.

Relational terms herein, such as first and second, may be used solely to distinguish one entity or operation from another entity or operation without necessarily requiring or implying any such actual relationship or order between these entities or operations.

The above descriptions are merely the embodiments of the present application and are not intended to limit the protection scope of the present application. For those skilled in the art, the present application can be modified and varied in many ways. Any modification, equivalent substitution, improvement, and the like made within the spirit and principle of the present application shall all fall within the protection scope of the present application.

## Claims

1. An electrical box system, comprising:
a plurality of electrical boxes, wherein the plurality of electrical boxes do not share a common ground; and
each of the plurality of electrical boxes comprises a housing, as well as a battery cell and an insulation detection assembly disposed within the housing; one end of the insulation detection assembly is connected to a positive electrode of the battery cell, and the other end of the insulation detection assembly is connected to a negative electrode of the battery cell; a reference ground of the insulation detection assembly is the housing.

2. The electrical box system according to claim 1, wherein the insulation detection assembly comprises a first insulation resistor, a second insulation resistor, and a first insulation detector, wherein
a first end of the first insulation resistor is connected to the positive electrode of the battery cell, and a second end of the first insulation resistor is connected to the second insulation resistor;
a first end of the second insulation resistor is connected to the negative electrode of the battery cell, and a second end of the second insulation resistor is connected to the first insulation resistor; and
the first insulation detector is used for acquiring a voltage value of the first insulation resistor and a voltage value of the second insulation resistor.

3. The electrical box system according to claim 2, wherein the first insulation detector comprises a first insulation detection module and a second insulation detection module, wherein
the first insulation detection module is connected in parallel with the first insulation resistor and used for detecting the voltage value of the first insulation resistor; and
the second insulation detection module is connected in parallel with the second insulation resistor and used for detecting the voltage value of the second insulation resistor.

4. The electrical box system according to any one of claims 1 to 3, wherein the insulation detection assembly comprises a third insulation resistor, a fourth insulation resistor, and a second insulation detector, wherein
one end of the third insulation resistor is connected to the positive electrode of the battery cell, and the other end of the third insulation resistor is connected to the fourth insulation resistor;
one end of the fourth insulation resistor is connected to the negative electrode of the battery cell, and the other end of the fourth insulation resistor is connected to the third insulation resistor; and
the second insulation detector is connected in parallel with the third insulation resistor.

5. The electrical box system according to any one of claims 1 to 4, wherein the insulation detection assembly comprises a third insulation resistor, a fourth insulation resistor, and a second insulation detector, wherein
one end of the third insulation resistor is connected to the positive electrode of the battery cell, and the other end of the third insulation resistor is connected to the fourth insulation resistor;
one end of the fourth insulation resistor is connected to the negative electrode of the battery cell, and the other end of the fourth insulation resistor is connected to the third insulation resistor; and
the second insulation detector is connected in parallel with the fourth insulation resistor.

6. The electrical box system according to claim 4 or 5, wherein the second insulation detector comprises a first analog-to-digital converter, a second analog-to-digital converter, as well as a capacitor, a resistor, and an alternating current power source that are sequentially connected in series, wherein
the first analog-to-digital converter is used for acquiring a first amplitude and a first phase between the capacitor and the resistor; and
the second analog-to-digital converter is used for acquiring a second amplitude and a second phase between the resistor and the alternating current power source.

7. The electrical box system according to any one of claims 1 to 6, wherein the plurality of electrical boxes are connected in series, in parallel, or in series-parallel.

8. The electrical box system according to claim 7, wherein for a case where the plurality of electrical boxes are connected in parallel, each of the plurality of electrical boxes is connected to a main positive terminal through a main positive relay and to a main negative terminal through a main negative relay.

9. An electrical box system, comprising a first electrical box group and a second electrical box group connected with each other, wherein the first electrical box group and the second electrical box group do not share a common ground;
the first electrical box group comprises a first insulation detection module and a plurality of first electrical boxes sharing a common ground, and the first insulation detection module is used for performing insulation detection on the plurality of first electrical boxes sharing the common ground;
the second electrical box group comprises a plurality of second electrical boxes that do not share a common ground, and each of the plurality of second electrical boxes comprises a housing, as well as a battery cell and a second insulation detection module disposed within the housing; one end of the second insulation detection module is connected to a positive electrode of the battery cell, and the other end of the second insulation detection module is connected to a negative electrode of the battery cell; a reference ground of the second insulation detection module is the housing.

10. A power supply system, comprising a battery management system and the electrical box system according to any one of claims 1 to 9, wherein
the battery management system is connected to the electrical box system.

11. A vehicle, comprising the power supply system according to claim 10.
